# EUROPEAN PATENT APPLICATION

(11) **EP 4 814 509 A1**
(43) Date of publication of application: **30.09.2026**
(21) Application number: 25837475.0
(22) Date of filing: 03.07.2025
(51) Int. Cl.: G01R 31/382, G01R 31/392, G01R 31/396, G01R 31/367, G01R 19/12, G01R 19/165

(54) **APPARATUS AND METHOD FOR DIAGNOSING BATTERY**

(30) Priority: 12.07.2024 KR 20240092483
(71) Applicant: LG Energy Solution, Ltd., Seoul 07335 (KR)
(72) Inventor: SONG, Hee-Seok, Daejeon 34122 (KR); KIM, Dae-Soo, Daejeon 34122 (KR); BAE, Yoon-Jung, Daejeon 34122 (KR); CHOI, Soon-Ju, Daejeon 34122 (KR)
(74) Representative: Goddar, Heinz J.
(86) International application number: PCT/KR2025/009528
(87) International publication number: WO 2026/014811

(57) **Abstract**

An apparatus for diagnosing a battery according to an embodiment of the present disclosure comprises a profile obtaining unit configured to obtain a voltage profile representing a voltage of a battery for a plurality of cycles; and a control unit configured to calculate a first voltage change rate for at least one cycle based on the voltage profile, compare the calculated at least one first voltage change rate with a preset first reference change rate, and diagnose a state of the battery based on the comparison result.

## Description

### TECHNICAL FIELD

This application is based on and claims priority from Korean Patent Application No. 10-2024-0092483, filed on July 12, 2024, with the Korean Intellectual Property Office, the disclosure of which is incorporated herein in its entirety by reference.

The present disclosure relates to an apparatus and method for diagnosing a battery, and more particularly, to an apparatus and method for diagnosing a battery, which may diagnose whether lithium is deposited in a battery.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

Although much research is being conducted on these batteries in terms of high capacity and high density, improving lifespan and safety is also important. In order to improve battery safety, technology that accurately diagnoses the current state of the battery is required.

In particular, it is necessary to prevent the phenomenon of lithium deposition on the surface of the negative electrode (lithium plating). If lithium is deposited on the surface of the negative electrode, it causes side reactions with the electrolyte and changes in the kinetic balance of the battery, which causes battery deterioration.

### DISCLOSURE

### Technical Problem

The present disclosure is designed to solve the problems of the related art, and therefore the present disclosure is directed to providing an apparatus and method for diagnosing a battery, which may diagnose whether lithium is deposited in a battery.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

An apparatus for diagnosing a battery according to one aspect of the present disclosure may comprise a profile obtaining unit configured to obtain a voltage profile representing a voltage of a battery for a plurality of cycles; and a control unit configured to calculate a first voltage change rate for at least one cycle based on the voltage profile, compare the calculated at least one first voltage change rate with a preset first reference change rate, and diagnose a state of the battery based on the comparison result.

The control unit may be configured to diagnose the state of the battery as a lithium plating state when at least one of the first voltage change rates is greater than or equal to the first reference change rate.

The control unit may be configured to: select a target cycle corresponding to the first voltage change rate that is greater than or equal to the first reference change rate, determine a cycle section for the selected target cycle based on a preset section size, and diagnose the state of the battery as a lithium plating state when at least one of second voltage change rates for the determined cycle section is greater than or equal to a preset second reference change rate.

The first reference change rate may be preset to a value greater than or equal to the second reference change rate.

The first reference change rate may be preset to a value lower than or equal to a voltage change rate corresponding to a first cycle of the voltage profile.

The control unit may be configured to: calculate the first voltage change rate for each of the plurality of cycles, select a target cycle whose corresponding first voltage change rate is greater than or equal to the first reference change rate among the plurality of cycles, and determine a minimum cycle among the selected target cycles as a start cycle for lithium plating.

The control unit may be configured to: determine a cycle section for the selected target cycle based on a preset section size, calculate a second voltage change rate for the determined cycle section, and determine a minimum cycle whose corresponding second voltage change rate is greater than or equal to a preset second reference change rate among the selected target cycles as the start cycle for lithium plating.

The control unit may be configured to calculate the first voltage change rate for a cycle greater than or equal to a preset reference cycle among the plurality of cycles.

The control unit may be configured to set a usage condition of the battery, including at least one of a maximum allowable C-rate, a maximum allowable temperature, and a maximum allowable SOC, based on the state of the battery.

The voltage of the battery may be an OCV of the battery measured after discharge of the battery is completed in each of the plurality of cycles.

A battery pack according to another aspect of the present disclosure may comprise the apparatus for diagnosing a battery according to one aspect of the present disclosure.

A server according to still another aspect of the present disclosure may comprise the apparatus for diagnosing a battery according to one aspect of the present disclosure.

A method for diagnosing a battery according to still another aspect of the present disclosure may comprise a profile obtaining step of obtaining a voltage profile representing a voltage of a battery for a plurality of cycles; a voltage change rate calculating step of calculating a first voltage change rate for at least one cycle based on the voltage profile; a comparing step of comparing the calculated at least one first voltage change rate with a preset first reference change rate; and a battery state diagnosing step of diagnosing a state of the battery based on the comparison result of the comparing step.

### Advantageous Effects

According to one aspect of the present disclosure, the apparatus for diagnosing a battery has the advantage of being able to non-destructively diagnose whether lithium plating has occurred in the battery based on the voltage change rate per cycle of the battery.

Furthermore, the apparatus for diagnosing a battery has the advantage of being able to diagnose the start point (start cycle) of lithium plating.

Furthermore, the apparatus for diagnosing a battery has the advantage of being able to set usage conditions of the battery to prevent further lithium plating, even if lithium plating has already occurred in the battery.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically illustrating an apparatus for diagnosing a battery according to an embodiment of the present disclosure.
FIG. 2 is a drawing illustrating an example of a first voltage profile according to an embodiment of the present disclosure.
FIG. 3 is a drawing schematically illustrating a differential profile for the first voltage profile.
FIG. 4 is a drawing schematically illustrating another example of the first voltage profile according to an embodiment of the present disclosure.
FIG. 5 is a drawing schematically illustrating first to fifth voltage profiles.
FIG. 6 is a drawing schematically illustrating a battery pack according to another embodiment of the present disclosure.
FIG. 7 is a drawing schematically illustrating a server according to still another embodiment of the present disclosure.
FIG. 8 is a drawing schematically illustrating a vehicle according to still another embodiment of the present disclosure.
FIG. 9 is a diagram schematically showing a method for diagnosing a battery according to still another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, a preferred embodiment of the present disclosure will be described in detail with reference to the accompanying drawings.

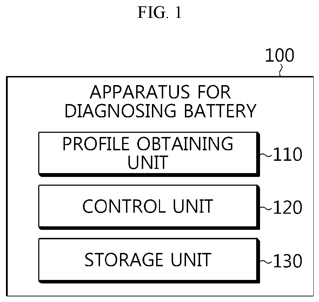

FIG. 1 is a diagram schematically illustrating an apparatus 100 for diagnosing a battery according to an embodiment of the present disclosure.

Referring to FIG. 1, the apparatus 100 for diagnosing a battery may include a profile obtaining unit 110 and a control unit 120.

Here, the battery refers to an independent cell that has a negative terminal and a positive terminal and is physically separable. As an example, a lithium-ion battery or a lithium polymer battery may be considered as a battery. In addition, the type of batteries may be a cylindrical type, a prismatic type or a pouch type. Additionally, the battery may mean a battery bank, a battery module or a battery pack in which a plurality of cells are connected in series and/or parallel. Below, for convenience of explanation, the battery is explained as meaning one independent cell.

The profile obtaining unit 110 may be configured to obtain a voltage profile representing the voltage of the battery for a plurality of cycles.

Specifically, the profile obtaining unit 110 may obtain a voltage profile in which the voltage of the battery corresponding to each cycle is mapped. Here, the voltage of the battery is a value measured for each cycle, and is a voltage value measured under the same conditions in a plurality of cycles.

Specifically, the voltage of the battery may be the OCV (Open Circuit Voltage) of the battery measured after the discharge of the battery is completed for each of a plurality of cycles. That is, when the voltage of the battery reaches a preset discharge termination voltage, the battery may be in a no-load state for a predetermined period of time. In this state, the OCV of the battery may be measured, and the voltage of the battery for the corresponding cycle may be recorded in a voltage profile.

In one embodiment, the discharge termination voltage may be preset to a lower limit voltage (e.g., 2.8 V) set for the battery.

In another embodiment, since discharging the battery to a lower limit voltage (e.g., 2.8 V) at each cycle may accelerate battery degradation, the discharge termination voltage may be preset to a voltage higher than the lower limit voltage. For example, the discharge termination voltage may be preset to a voltage (e.g., about 2.94 V) corresponding to about 10% of the SOC (State of Charge) based on the BOL (Beginning of Life) state.

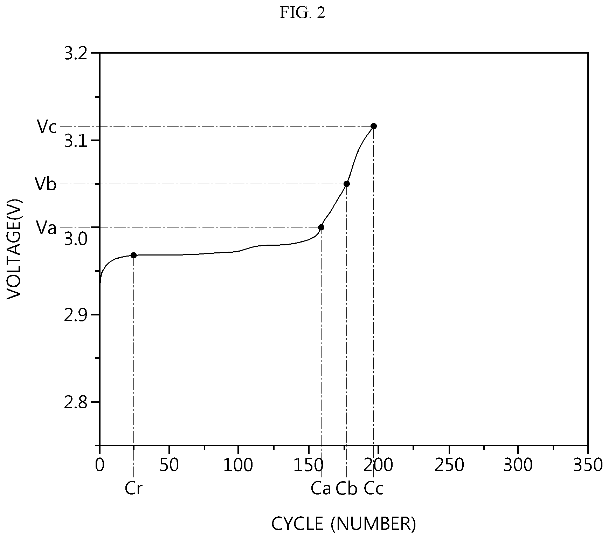

FIG. 2 is a drawing illustrating an example of a first voltage profile VP1 according to an embodiment of the present disclosure. Here, the first voltage profile VP1 may be expressed as an X-Y graph where the X-axis is set to cycle and the Y-axis is set to voltage.

For example, the profile obtaining unit 110 may directly receive the voltage profile of the battery from the outside. That is, the profile obtaining unit 110 may obtain the voltage profile by being connected to the outside via wire and/or wirelessly and receiving the voltage profile.

As another example, the profile obtaining unit 110 may receive battery information about the voltage of the battery for each cycle. Then, the profile obtaining unit 110 may generate a voltage profile based on the received battery information. That is, the profile obtaining unit 110 may obtain a voltage profile by directly generating the voltage profile based on the battery information.

The profile obtaining unit 110 may be connected to the control unit 120 so as to be able to communicate with it. For example, the profile obtaining unit 110 may be connected to the control unit 120 by wire and/or wirelessly. The profile obtaining unit 110 may transmit the obtained voltage profile to the control unit 120.

The control unit 120 may be configured to calculate the first voltage change rate for at least one cycle based on the voltage profile.

Specifically, the control unit 120 may calculate the first voltage change rate for at least one cycle by calculating the change rate of voltage for the cycle. That is, the first voltage change rate may be a value obtained by differentiating voltage for the cycle.

The control unit 120 may calculate the first voltage change rate for one cycle included in the voltage profile, or may calculate the first voltage change rate for a plurality of cycles.

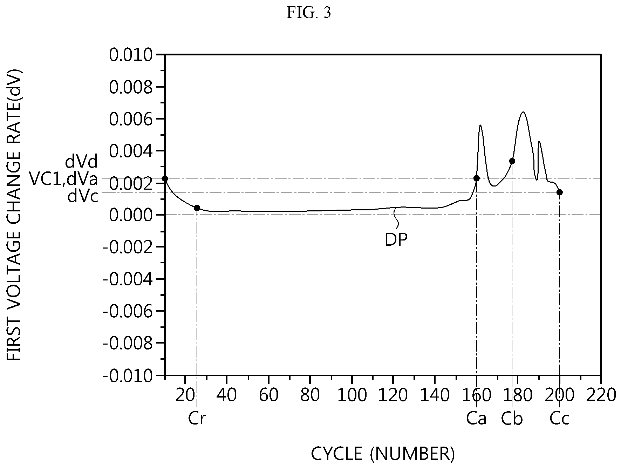

FIG. 3 is a drawing schematically illustrating a differential profile DP for the first voltage profile. Here, the differential profile DP may be expressed as an X-Y graph where the X-axis is set to cycle and the Y-axis is set to the first voltage change rate.

For example, in the embodiments of FIGS. 2 and 3, the control unit 120 may calculate the first voltage change rate for the Ca cycle, the Cb cycle, and the Cc cycle. The first voltage change rate of the Ca cycle is dVa, the first voltage change rate of the Cb cycle is dVb, and the first voltage change rate of the Cc cycle is dVc.

The control unit 120 may be configured to compare the calculated at least one first voltage change rate with a preset first reference change rate.

Specifically, the control unit 120 may compare the magnitude of the first voltage change rate and the first reference change rate. That is, control unit 120 may directly compare the magnitude of the first voltage change rate and the first reference change rate.

For example, in the embodiment of FIG. 3, it is assumed that the first reference change rate is preset to VC1. The control unit 120 may compare the first reference change rate VC1 with the first voltage change rate (dVa) of the Ca cycle, the first voltage change rate (dVb) of the Cb cycle, and the first voltage change rate (dVc) of the Cc cycle, respectively.

The control unit 120 may be configured to diagnose the state of the battery based on the comparison result.

Specifically, the control unit 120 may diagnose the state of the battery as a normal state or a lithium plating state based on the comparison result between the first reference change rate and the first voltage change rate. A specific example of the first reference change rate will be described later.

Here, the normal state refers to a state where lithium plating does not occur in the battery. And, the lithium plating state refers to a state where lithium plating, in which lithium metal is deposited in the battery, occurs.

For example, the control unit 120 may be configured to diagnose the state of the battery as a lithium plating state if at least one of the first voltage change rates is greater than or equal to the first reference change rate. That is, if even the first voltage change rate corresponding to one cycle is greater than or equal to the first reference change rate, the control unit 120 may diagnose the state of the battery as a lithium plating state. Conversely, the control unit 120 may diagnose the state of the battery as a normal state if all of the calculated one or more first voltage change rates are less than the first reference change rate.

Specifically, when lithium plating occurs, the intercalation of lithium ions into the graphite layer does not proceed smoothly, so the voltage of the battery may increase even after the discharge of the battery is terminated. In particular, as the degree of lithium plating becomes more severe (i.e., as the amount of lithium deposited increases), the voltage increase after discharge termination may become larger. Therefore, the control unit 120 may diagnose whether lithium plating has occurred in the battery by considering the first voltage change rate, which represents the voltage increase after discharge termination.

The apparatus 100 for diagnosing a battery according to an embodiment of the present disclosure has the advantage of being able to non-destructively diagnose whether lithium plating has occurred in a battery based on the voltage change rate per cycle of the battery.

Meanwhile, the profile obtaining unit 110 and the control unit 120 included in the apparatus 100 for diagnosing a battery may optionally include processors, application-specific integrated circuits (ASICs), other chipsets, logic circuits, registers, communication modems, data processing devices, etc. known in the art to execute various control logics performed in the present disclosure. Also, when the control logic is implemented as software, the profile obtaining unit 110 and the control unit 120 may be implemented as a set of program modules. At this time, the program module may be stored in the memory and executed by the profile obtaining unit 110 and the control unit 120. The memory may be inside or outside the profile obtaining unit 110 and the control unit 120 and may be connected to the profile obtaining unit 110 and the control unit 120 by various well-known means.

In addition, the apparatus 100 for diagnosing a battery may further include a storage unit 130. The storage unit 130 may store data necessary for operation and function of each component of the apparatus 100 for diagnosing a battery, data generated in the process of performing the operation or function, or the like. The storage unit 130 is not particularly limited in its kind as long as it is a known information storage means that can record, erase, update and read data. As an example, the information storage means may include RAM, flash memory, ROM, EEPROM, registers, and the like. In addition, the storage unit 130 may store program codes in which processes executable by the profile obtaining unit 110 and the control unit 120 are defined.

Preferably, the control unit 120 may be configured to calculate the first voltage change rate for a cycle greater than or equal to a preset reference cycle among a plurality of cycles.

Specifically, even if lithium plating does not occur in the initial cycle, the voltage of the battery may gradually increase. For example, since the negative electrode stabilization phase of the battery progresses in the initial cycle, the OCV of the battery may gradually increase after the discharge is completed.

In the embodiment of FIG. 2, the voltage of the battery gradually increases below the Cr cycle, the voltage of the battery is maintained at a constant level after the Cr cycle, and the voltage of the battery increases rapidly after about the Ca cycle. Therefore, the reference cycle may be preset to the Cr cycle. For example, the reference cycle may be preset to about 25 cycles.

That is, considering the electrochemical state change of the battery, the first voltage change rate in the initial cycle may be higher than or equal to the first reference change rate due to causes unrelated to lithium plating. If the state of the battery is diagnosed for the entire cycle without considering these battery characteristics, the state of the battery may be incorrectly diagnosed. Therefore, the apparatus 100 for diagnosing a battery may prevent incorrect diagnosis of the state of the battery by diagnosing the state of the battery in cycles greater than or equal to the reference cycle.

Below, a specific example of the first reference change rate is described.

In one embodiment, the first reference change rate is a preset value, which may be determined theoretically or experimentally. For example, the first reference change rate may be preset to 0.002. That is, if a first voltage change rate greater than or equal to 0.002 exists, the state of the battery may be diagnosed as a lithium plating state.

In another embodiment, the first reference change rate may be preset to a value lower than or equal to the voltage change rate corresponding to the first cycle of the voltage profile.

If the first reference change rate is set too low, even though the first voltage change rate of the battery increases slightly, the state of the battery may be diagnosed as a lithium plating state. Since the usage conditions of the battery may be strictly adjusted or the battery use may be inhibited if lithium plating occurs, if the state of the battery is incorrectly diagnosed as a lithium plating state, the utility of the battery may be seriously reduced.

Conversely, if the first reference change rate is set too high, the state of the battery may be misdiagnosed as a normal state, even though lithium plating has actually occurred. In this case, accidents such as venting and explosion due to swelling may occur.

Preferably, the first reference change rate may be set to a value lower than or equal to the first voltage change rate of the first cycle of the battery. More preferably, the first reference change rate may be set to the first voltage change rate of the first cycle of the battery.

In the embodiment of FIG. 3, the first voltage change rate in the first cycle is largest as VC1 below the reference cycle Cr. For example, the first reference change rate may be set to the first voltage change rate VC1 of the first cycle. As another example, the first reference change rate may be set to a value lower than or equal to the first voltage change rate VC1 of the first cycle.

The apparatus 100 for diagnosing a battery according to an embodiment of the present disclosure may set the first reference change rate, which serves as a standard for diagnosing the state of the battery, based on the first voltage change rate in the initial cycle of the battery. That is, the apparatus 100 for diagnosing a battery does not set the first reference change rate to a uniform value, but sets it by considering the state of each battery, so it has the advantage of being able to diagnose the state of the battery more adaptively.

The control unit 120 may be configured to select a target cycle corresponding to the first voltage change rate greater than or equal to a first reference change rate.

For example, in the embodiment of FIG. 3, assuming that the first reference change rate is set to VC1, the control unit 120 may select the Ca cycle and the Cb cycle as target cycles.

The control unit 120 may be configured to determine a cycle section for the selected target cycle based on a preset section size.

Here, the section size may be preset to a size that may confirm the voltage change behavior of the battery. For example, the section size may be preset to a size greater than or equal to 1 cycle. In the following description, it is assumed that the section size is preset to R cycles.

Specifically, the cycle section may include sections corresponding to a preset section size from a target cycle. For example, assuming that the target cycle is n cycles and the preset section size is R, the cycle section for n cycles means n to n+R cycles.

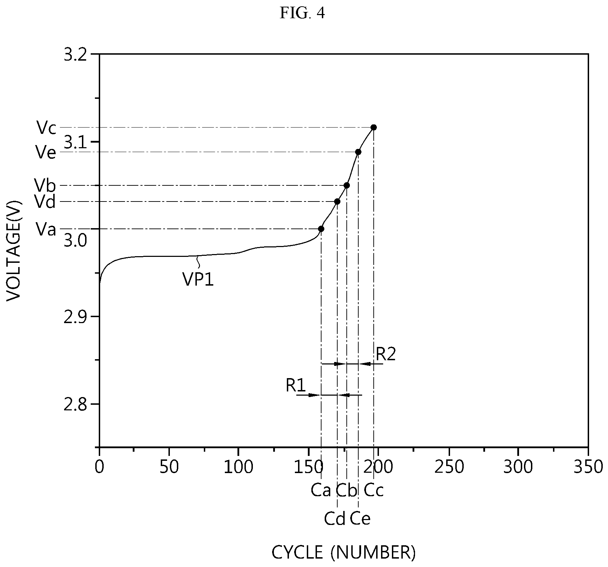

FIG. 4 is a drawing schematically illustrating another example of the first voltage profile VP1 according to an embodiment of the present disclosure. For example, the first cycle section R1 for the Ca cycle is Ca to Cd cycles, which satisfy the equation "Cd = Ca + R". Furthermore, the second cycle section R2 for the Cb cycle is Cb to Ce cycles, which satisfy the equation "Ce = Cb + R".

However, a target cycle whose cycle section cannot be determined among the target cycles may be excluded from the process of diagnosing the state of the battery. For example, the cycle section refers to a section with a preset section size from the target cycle. In other words, a cycle whose difference from the last cycle is greater than or equal to the preset section size may be determined as the target cycle.

For example, in the embodiments of FIGS. 2 and 3, multiple target cycles in which the first voltage change rate is greater than or equal to the first reference change rate VC1 exist between the Cb cycle and the Cc cycle. However, the cycle section set based on these target cycles includes cycles exceeding the Cc cycle.

For example, it is assumed that the Cs cycle (not shown) located between the Cb cycle and the Cc cycle corresponds to a target cycle in which the first voltage change rate is greater than or equal to the first reference change rate VC1, and the equation "R > Cc - Cs" is satisfied. Here, R is the preset section size.

Since the cycle section set based on the Cs cycle is the Cs to Cs+R cycles, the set cycle section includes cycles exceeding the Cc cycle. Since the voltage profile does not contain voltage data for cycles exceeding the Cc cycle, the Cs cycle may be excluded in the process of diagnosing the state of the battery even though it corresponds to the target cycle.

The control unit 120 may be configured to diagnose the state of the battery as a lithium plating state if at least one of the second voltage change rates for the determined cycle section is greater than or equal to a preset second reference change rate.

Specifically, the control unit 120 may calculate a second voltage change rate for the determined cycle section. Here, the second voltage change rate is an average voltage change rate for the corresponding cycle section. That is, the average voltage change rate during the cycle section may be calculated as the second voltage change rate.

In the embodiment of FIG. 4, the voltage corresponding to the Ca cycle is Va, and the voltage corresponding to the Cd cycle is Vd. The control unit 120 may calculate the second voltage change rate of the first cycle section R1 according to the formula "(Vd - Va) ÷ (Cd - Ca)".

In addition, in the embodiment of FIG. 4, the voltage corresponding to the Cb cycle is Vb, and the voltage corresponding to the Ce cycle is Ve. The control unit 120 may calculate the second voltage change rate of the second cycle section R2 according to the formula "(Ve - Vb) ÷ (Ce - Cb)".

In addition, the control unit 120 may compare each of the calculated second voltage change rates with a preset second reference change rate. Here, the first reference change rate may be preset to a value higher than or equal to the second reference change rate. That is, since the second reference change rate is a value compared to the average change rate of the voltage for the cycle section, it may be set to a value lower than or equal to the first reference change rate compared to the instantaneous change rate of the voltage for the cycle.

If at least one of the calculated second voltage change rates is greater than or equal to the second reference change rate, the control unit 120 may diagnose the state of the battery as a lithium plating state. Specifically, the target cycle that serves as the criterion for calculating the second voltage change rate is a cycle in which the corresponding first voltage change rate is greater than or equal to the first reference change rate. That is, the control unit 120 may diagnose the state of the battery as a lithium plating state if a cycle in which the corresponding first voltage change rate is greater than or equal to the first reference change rate and the corresponding second voltage change rate is greater than or equal to the second reference change rate exists.

For example, in the embodiment of FIG. 3, the first voltage change rate of the Ca cycle is dVa, which is equal to the first reference change rate VC1, and the first voltage change rate of the Cb cycle is dVb, which is greater than the first reference change rate VC1. In addition, in the embodiments of FIGS. 3 and 4, since the second voltage change rates of the first cycle section R1 and the second cycle section R2 are greater than the first reference change rate VC1, they are greater than or equal to the second reference change rate. Therefore, the control unit 120 may diagnose the state of the battery as a lithium plating state.

Contrary to the embodiments of FIGS. 3 and 4, it is assumed that the first voltage change rate after the Ca cycle and the Cb cycle decreases rapidly, and thus the second voltage change rates of the first cycle section R1 and the second cycle section R2 are less than the second reference change rate. In this case, even though the first voltage change rates corresponding to the Ca cycle and the Cb cycle are greater than or equal to the first reference change rate VC1, the control unit 120 may diagnose the state of the battery as a normal state.

For example, since the first voltage change rate represents the instantaneous voltage change rate for a cycle, the first voltage change rate may be calculated to be higher than the actual value due to various reasons such as voltage measurement noise or process noise. In other words, if the battery state is diagnosed by considering only the voltage change rate for one cycle, the state of the battery may be misdiagnosed. Therefore, the apparatus 100 for diagnosing a battery has the advantage of being able to diagnose the state of the battery more accurately by considering both the first voltage change rate and the second voltage change rate.

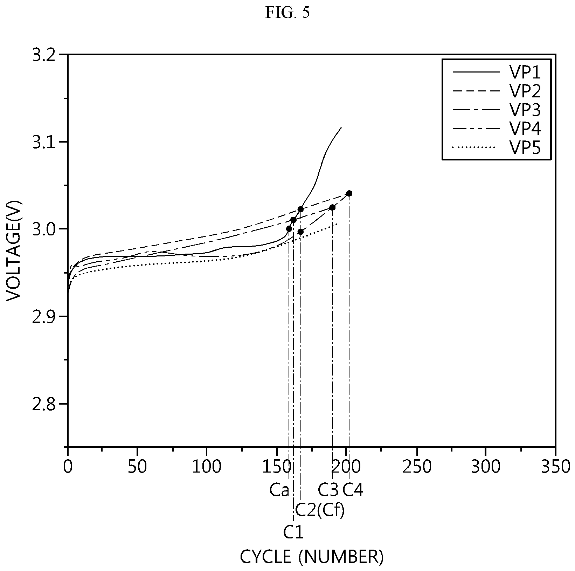

FIG. 5 is a drawing schematically illustrating first to fifth voltage profiles VP1, VP2, VP3, VP4, and VP5.

Specifically, the first to fifth voltage profiles VP1, VP2, VP3, VP4, and VP5 are voltage profiles for the first to fifth batteries, respectively. That is, the first to fifth voltage profiles VP1, VP2, VP3, VP4, and VP5 are profiles representing the OCV after discharge termination for each cycle for the first to fifth batteries, respectively.

Also, the first battery and the fourth battery are in a lithium plating state, and the second battery, the third battery, and the fifth battery are in a normal state. In the first battery, lithium plating has occurred in the Ca cycle, and in the fourth battery, lithium plating has occurred in the Cf cycle.

The voltage of the first battery and the voltage of the second battery are the same in the C2 cycle, but the state of the first battery is the lithium plating state, while the state of the second battery is the normal state. Also, the voltage of the first battery and the voltage of the third battery are the same in the C1 cycle, but the state of the first battery is the lithium plating state, while the state of the third battery is the normal state.

The voltage of the fourth battery and the voltage of the second battery are the same in the C4 cycle, but the state of the fourth battery is the lithium plating state, while the state of the second battery is the normal state. Also, the voltage of the fourth battery and the voltage of the third battery are the same in the C3 cycle, but the state of the fourth battery is the lithium plating state, while the state of the third battery is the normal state.

That is, even if the voltage of the battery is the same for each cycle, the state of the battery may be completely different, so the state of the battery cannot be accurately diagnosed based on the voltage of the battery for each cycle. Therefore, the apparatus 100 for diagnosing a battery according to an embodiment of the present disclosure has the advantage of being able to more accurately diagnose the state of the battery by considering the voltage change rate of the battery.

Below, an embodiment in which the control unit 120 determines the start cycle of lithium plating is described. That is, the control unit 120 may not only diagnose whether the state of the battery is a lithium plating state, but also determine the start cycle in which lithium plating of the battery begins.

In one embodiment, the control unit 120 may determine the start cycle of lithium plating based on the result of comparing the first voltage change rate and the first reference change rate.

The control unit 120 may be configured to calculate a first voltage change rate for each of a plurality of cycles. Preferably, the control unit 120 may calculate the first voltage change rate for a plurality of cycles included in the voltage profile to accurately determine a start cycle in which lithium plating begins. More preferably, the control unit 120 may calculate the first voltage change rate for a cycle greater than or equal to a preset reference cycle among the plurality of cycles included in the voltage profile.

For example, in the embodiment of FIG. 2, the control unit 120 may calculate the first voltage change rate for each of the Cr to Cc cycles.

The control unit 120 may be configured to select a target cycle whose corresponding first voltage change rate is greater than or equal to the first reference change rate among a plurality of cycles. In addition, the control unit 120 may be configured to determine a minimum cycle among the selected target cycles as the start cycle of lithium plating.

Specifically, if lithium plating occurs, the voltage of the battery may increase even after the discharge of the battery is completed. Therefore, the control unit 120 may determine the minimum cycle among the cycles in which the first voltage change rate of the battery is greater than or equal to the first reference change rate as the start cycle of lithium plating.

The apparatus 100 for diagnosing a battery has the advantage of not only being able to diagnose the state of the battery as a normal state or a lithium plating state, but also being able to determine the cycle in which lithium plating in the battery has begun. That is, according to the apparatus 100 for diagnosing a battery, since the start cycle of lithium plating may be determined, the lithium plating state of the battery may be tracked and diagnosed. Specifically, whether lithium plating has additional occurred in the battery and the amount of lithium deposited may be tracked and diagnosed.

For example, in the embodiment of FIG. 3, after the Ca cycle, three peaks (points with an upward convex shape) exist. In this case, it may be diagnosed that lithium plating has occurred a total of three times. Additionally, the integral value for the cycle section where the first voltage change rate is greater than or equal to the first reference change rate may be diagnosed as the amount of lithium deposited.

In another embodiment, the control unit 120 may determine the start cycle of lithium plating based on the results of comparing the first voltage change rate with the first reference change rate and comparing the second voltage change rate with the second reference change rate.

The control unit 120 may be configured to determine a cycle section for the selected target cycle based on a preset section size. In addition, the control unit 120 may be configured to calculate a second voltage change rate for the determined cycle section. Here, the preset section size, the target cycle, the cycle section, and the second voltage change rate described are the same as those described above, so a detailed description thereof is omitted.

The control unit 120 may be configured to determine a minimum cycle in which the corresponding second voltage change rate is greater than or equal to the preset second reference change rate among the selected target cycles as the start cycle of lithium plating.

As previously explained, the first voltage change rate may differ from the actual value due to the influence of various noises. Therefore, to prevent misdiagnosis due to noise, the second voltage change rate for a certain cycle section may be considered. Accordingly, the control unit 120 may determine the cycle section for each target cycle and calculate the second voltage change rate for each determined cycle section. In addition, the control unit 120 may determine the minimum cycle in which the second voltage change rate is greater than or equal to the second reference change rate as the start cycle for lithium plating.

The apparatus 100 for diagnosing a battery has the advantage of being able to more accurately determine the start cycle of lithium plating of the battery by considering both the corresponding first voltage change rate and the corresponding second voltage change rate.

Meanwhile, the control unit 120 may be configured to set a usage condition of the battery, including at least one of the maximum allowable C-rate, the maximum allowable temperature, and the maximum allowable SOC, based on the state of the battery.

Specifically, the control unit 120 may set the usage conditions of the battery to prevent lithium plating from additionally occurring on the battery. For example, the control unit 120 may set at least one of the maximum allowable C-rate, the maximum allowable temperature, and the maximum allowable SOC to be lower than a previously set value.

The apparatus 100 for diagnosing a battery according to the present disclosure may be applied to a battery management system (BMS). That is, the BMS according to the present disclosure may include the apparatus 100 for diagnosing a battery described above. In this configuration, at least some of components of the apparatus 100 for diagnosing a battery may be implemented by supplementing or adding functions of the components included in a conventional BMS. For example, the profile obtaining unit 110 and the control unit 120 of the apparatus 100 for diagnosing a battery may be implemented as components of the BMS.

Additionally, the apparatus 100 for diagnosing a battery according to the present disclosure may be provided in the battery pack. That is, the battery pack according to the present disclosure may include the above-described apparatus 100 for diagnosing a battery and at least one battery cell. Additionally, the battery pack may further include electrical components (relays, fuses, etc.) and a case.

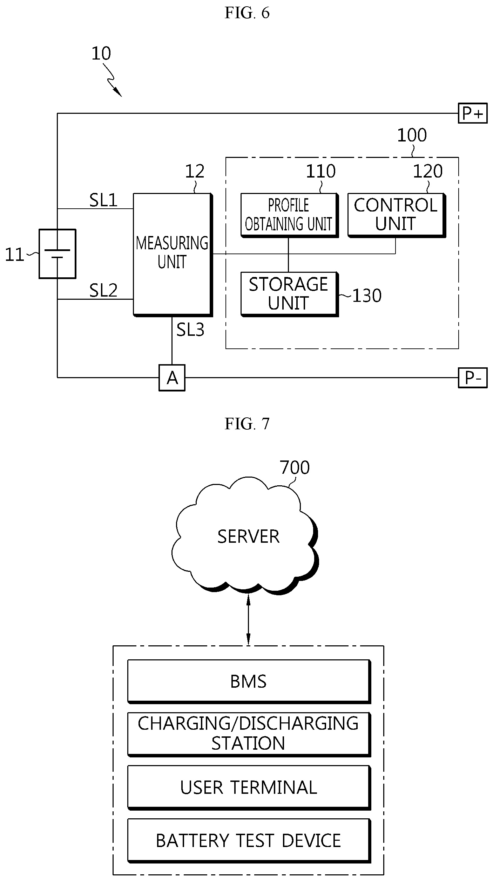

FIG. 6 is a diagram showing a battery pack including the apparatus 100 for diagnosing a battery according to an embodiment of the present disclosure.

The positive electrode terminal of the battery 11 may be connected to the positive electrode terminal P+ of the battery pack 10, and the negative electrode terminal of the battery 11 may be connected to the negative electrode terminal P- of the battery pack 10.

The measuring unit 12 may be connected to the first sensing line SL1, the second sensing line SL2, and the third sensing line SL3. Specifically, the measuring unit 12 may be connected to the positive electrode terminal of the battery 11 through the first sensing line SL1 and connected to the negative electrode terminal of the battery 11 through the second sensing line SL2. The measuring unit 12 may measure the voltage of the battery 11 based on the voltage measured at each of the first sensing line SL1 and the second sensing line SL2.

Also, the measuring unit 12 may be connected to the current measuring unit A through the third sensing line SL3. For example, the current measuring unit A may be an ammeter or a shunt resistor capable of measuring the charging current and the discharging current of the battery 11. The measuring unit 12 may measure the charging current of the battery 11 through the third sensing line SL3 to calculate the charge amount. In addition, the measuring unit 12 may measure the discharging current of the battery 11 through the third sensing line SL3 to calculate the discharge amount.

For example, the profile obtaining unit 110 may receive battery information about the voltage of the battery from the measuring unit 12. Then, the profile obtaining unit 110 may generate a voltage profile based on the battery information.

As another example, the profile obtaining unit 110 may receive a voltage profile from the measuring unit 12.

An external device may be connected to the positive electrode terminal P+ and the negative electrode terminal P- of the battery pack 10. For example, the external device may be a discharging device or a load. In addition, the positive electrode terminal of the battery 11, the positive electrode terminal P+ of the battery pack 10, the external device, the negative electrode terminal P- of the battery pack 10, and the negative electrode terminal of the battery 11 may be electrically connected.

FIG. 7 is a drawing schematically illustrating a server 700 according to still another embodiment of the present disclosure.

The server 700 according to another embodiment of the present disclosure may include the apparatus 100 for diagnosing a battery.

The server 700 may be configured to receive a voltage profile for a battery from the outside. Specifically, the server 700 may be connected to any device capable of generating and transmitting a voltage profile for a battery, so as to enable communication without restriction.

For example, the server 700 may be connected to one or more BMSs to enable wired and/or wireless communication. For example, the server 700 may be connected to enable communication with a BMS, a vehicle BMS installed in a vehicle, an ESS BMS installed in an ESS, etc.

As another example, the server 700 may be connected to communicate with a device capable of controlling the charging and discharging of a battery, such as a BMS or a charging/discharging station. In addition, the server 700 may be connected to communicate with one or more user terminals. In addition, the server 700 may be connected to communicate with a battery test device that tests the state of the battery.

The server 700 may diagnose the state of the corresponding battery based on the voltage profile, and set the usage condition for the battery based on the diagnosed state of the corresponding battery.

For example, if the state of the battery is diagnosed as a lithium plating state, the server 700 may reduce the set value for at least one of the maximum allowable temperature, the maximum allowable C-rate, and the maximum allowable SOC for the corresponding battery. In addition, the server 700 may feed back the changed set value to a device corresponding to the battery. The device corresponding to the battery may receive the changed set value from the server 700 and change the usage condition of the battery to correspond to the received set value. Accordingly, the corresponding battery may be operated according to the changed usage condition, thereby preventing additional occurrence of lithium plating.

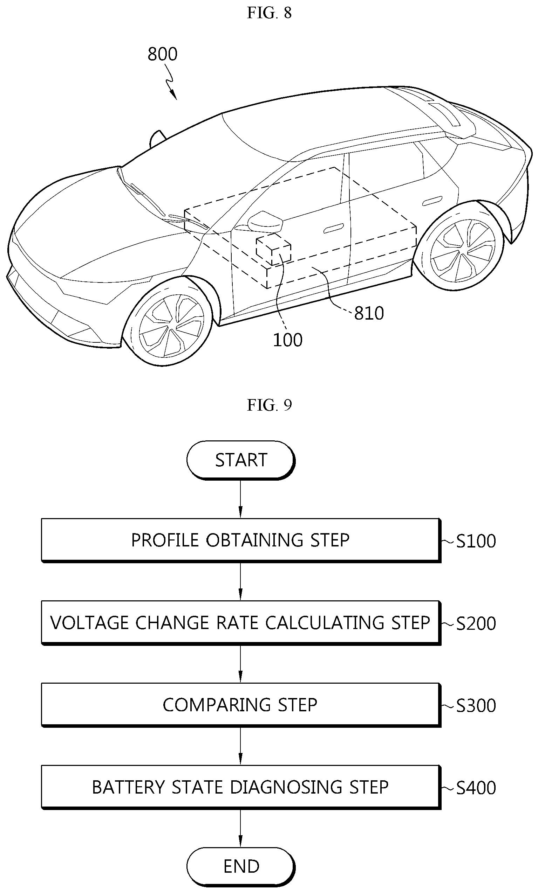

FIG. 8 is a drawing schematically illustrating a vehicle 800 according to another embodiment of the present disclosure.

Referring to FIG. 8, the battery pack 810 according to an embodiment of the present disclosure may be included in a vehicle 800, such as an electric vehicle (EV) or a hybrid vehicle (HV). In addition, the battery pack 810 may drive the vehicle 800 by supplying power to a motor through an inverter provided in the vehicle 800. Here, the battery pack 810 may include the apparatus 100 for diagnosing a battery. That is, the vehicle 800 may include the apparatus 100 for diagnosing a battery. In this case, the apparatus 100 for diagnosing a battery may be an onboard device included in the vehicle 800.

FIG. 9 is a diagram schematically showing a method for diagnosing a battery according to still another embodiment of the present disclosure.

Referring to FIG. 9, the method for diagnosing a battery may include a profile obtaining step (S100), a voltage change rate calculating step (S200), a comparing step (S300) and a battery state diagnosing step (S400).

Preferably, each step of the method for diagnosing a battery may be performed by the apparatus 100 for diagnosing a battery. Hereinafter, for convenience of explanation, contents overlapping with the previously described contents will be omitted or briefly described.

The profile obtaining step (S100) is a step of obtaining a voltage profile representing a voltage of a battery for a plurality of cycles, and may be performed by the profile obtaining unit 110.

For example, the profile obtaining unit 110 may directly receive the voltage profile of the battery from the outside. That is, the profile obtaining unit 110 may obtain the voltage profile by receiving the voltage profile while being connected to the outside via wire and/or wirelessly.

As another example, the profile obtaining unit 110 may receive battery information about the voltage of the battery for each cycle. Then, the profile obtaining unit 110 may generate a voltage profile based on the received battery information. That is, the profile obtaining unit 110 may obtain a voltage profile by directly generating the voltage profile based on the battery information.

The voltage change rate calculating step (S200) is a step of calculating a first voltage change rate for at least one cycle based on the voltage profile, and may be performed by the control unit 120.

Specifically, the control unit 120 may calculate the first voltage change rate for at least one cycle by calculating the change rate of voltage for the cycle. That is, the first voltage change rate may be a value obtained by differentiating voltage for the cycle.

The comparing step (S300) is a step of comparing the calculated at least one first voltage change rate with a preset first reference change rate, and may be performed by the control unit 120.

Specifically, the control unit 120 may compare the magnitude of the first voltage change rate and the first reference change rate. That is, control unit 120 may directly compare the magnitude of the first voltage change rate and the first reference change rate.

The battery state diagnosing step (S400) is a step for diagnosing a state of the battery based on the comparison result of the comparing step (S300), and may be performed by the control unit 120.

For example, the control unit 120 may be configured to diagnose the state of the battery as a lithium plating state if at least one of the first voltage change rates is greater than or equal to the first reference change rate.

As another example, the control unit 120 may diagnose the state of the battery as a normal state if all of the calculated one or more first voltage change rates are less than the first reference change rate.

The embodiments of the present disclosure described above may not be implemented only through an apparatus and a method, but may be implemented through a program that realizes a function corresponding to the configuration of the embodiments of the present disclosure or a storage medium on which the program is recorded. The program or storage medium may be easily implemented by those skilled in the art from the above description of the embodiments.

Another embodiment of the present disclosure may provide a computer-readable storage medium on which a program for performing the various embodiments described above on a computer is recorded.

The program may be implemented as hardware components, software components, and/or a combination of hardware components and software components. The program may be executed by any system capable of executing computer-readable instructions.

Software may include computer programs, codes, instructions, or a combination thereof, which may configure a processing device to perform a desired operation or may independently or collectively command a processing device.

The software may be implemented as a computer program including instructions stored on a computer-readable storage medium. Examples of the computer-readable storage medium include magnetic storage media (e.g., read-only memory (ROM), random-access memory (RAM), floppy disks, hard disks, etc.) and optical reading media (e.g., CD-ROM, DVD: Digital Versatile Disc). The computer-readable storage medium may be distributed across network-connected computer systems so that the computer-readable codes may be stored and executed in a distributed manner. The storage medium may be readable by a computer, stored in a memory, and executed by a processor.

A computer-readable storage medium may be provided in the form of a non-transitory storage medium. Here, the term 'non-transitory storage medium' simply means that it is a tangible device and does not contain signals (e.g., electromagnetic waves), and this term does not distinguish between cases where data is stored semi-permanently on the storage medium and cases where data is stored temporarily. For example, the 'non-transitory storage medium' may include a buffer in which data is temporarily stored.

Additionally, the program may be provided as part of a computer program product. The computer program product may be traded between sellers and buyers as a commodity.

A computer program product may include a software program, and a computer-readable storage medium storing the software program. For example, the computer program product may include a product in the form of a software program (e.g., a downloadable application) distributed electronically by a manufacturer of an electronic device or through an electronic market. For electronic distribution, at least a portion of the software program may be stored on a storage medium or temporarily generated. In this case, the storage medium may be a storage medium of a server of a manufacturer of an electronic device, a server of an electronic market, or a relay server that temporarily stores the software program.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### (Explanation of reference symbols)

10: battery pack
11: battery
12: measuring unit
100: apparatus for diagnosing a battery
110: profile obtaining unit
120: control unit
130: storage unit
700: server
800: vehicle
810: battery pack

## Claims

1. An apparatus for diagnosing a battery, comprising:
a profile obtaining unit configured to obtain a voltage profile representing a voltage of a battery for a plurality of cycles; and
a control unit configured to calculate a first voltage change rate for at least one cycle based on the voltage profile, compare the calculated at least one first voltage change rate with a preset first reference change rate, and diagnose a state of the battery based on the comparison result.

2. The apparatus for diagnosing a battery according to claim 1,
wherein the control unit is configured to diagnose the state of the battery as a lithium plating state when at least one of the first voltage change rates is greater than or equal to the first reference change rate.

3. The apparatus for diagnosing a battery according to claim 2,
wherein the control unit is configured to:
select a target cycle corresponding to the first voltage change rate that is greater than or equal to the first reference change rate,
determine a cycle section for the selected target cycle based on a preset section size, and
diagnose the state of the battery as a lithium plating state when at least one of second voltage change rates for the determined cycle section is greater than or equal to a preset second reference change rate.

4. The apparatus for diagnosing a battery according to claim 3,
wherein the first reference change rate is preset to a value greater than or equal to the second reference change rate.

5. The apparatus for diagnosing a battery according to claim 1,
wherein the first reference change rate is preset to a value lower than or equal to a voltage change rate corresponding to a first cycle of the voltage profile.

6. The apparatus for diagnosing a battery according to claim 1,
wherein the control unit is configured to:
calculate the first voltage change rate for each of the plurality of cycles,
select a target cycle whose corresponding first voltage change rate is greater than or equal to the first reference change rate among the plurality of cycles, and
determine a minimum cycle among the selected target cycles as a start cycle for lithium plating.

7. The apparatus for diagnosing a battery according to claim 6,
wherein the control unit is configured to:
determine a cycle section for the selected target cycle based on a preset section size,
calculate a second voltage change rate for the determined cycle section, and
determine a minimum cycle whose corresponding second voltage change rate is greater than or equal to a preset second reference change rate among the selected target cycles as the start cycle for lithium plating.

8. The apparatus for diagnosing a battery according to claim 1,
wherein the control unit is configured to calculate the first voltage change rate for a cycle greater than or equal to a preset reference cycle among the plurality of cycles.

9. The apparatus for diagnosing a battery according to claim 1,
wherein the control unit is configured to set a usage condition of the battery, including at least one of a maximum allowable C-rate, a maximum allowable temperature, and a maximum allowable SOC, based on the state of the battery.

10. The apparatus for diagnosing a battery according to claim 1,
wherein the voltage of the battery is an OCV of the battery measured after discharge of the battery is completed in each of the plurality of cycles.

11. A battery pack, comprising the apparatus for diagnosing a battery according to any one of claims 1 to 10.

12. A server, comprising the apparatus for diagnosing a battery according to any one of claims 1 to 10.

13. A method for diagnosing a battery, comprising:
a profile obtaining step of obtaining a voltage profile representing a voltage of a battery for a plurality of cycles;
a voltage change rate calculating step of calculating a first voltage change rate for at least one cycle based on the voltage profile;
a comparing step of comparing the calculated at least one first voltage change rate with a preset first reference change rate; and
a battery state diagnosing step of diagnosing a state of the battery based on the comparison result of the comparing step.

14. A computer-readable storage medium storing a computer program for executing a method for diagnosing a battery, the method including:
a profile obtaining step of obtaining a voltage profile representing a voltage of a battery for a plurality of cycles;
a voltage change rate calculating step of calculating a first voltage change rate for at least one cycle based on the voltage profile;
a comparing step of comparing the calculated at least one first voltage change rate with a preset first reference change rate; and
a battery state diagnosing step of diagnosing a state of the battery based on the comparison result of the comparing step.
